# EUROPÄISCHE PATENTANMELDUNG

(11) **EP 2 429 267 A1**
(43) Veröffentlichungstag der Anmeldung: **14.03.2012**
(21) Anmeldenummer: 11180229.4
(22) Anmeldetag: 06.09.2011
(51) Int. Cl.: H05K 1/02

(54) **Mehrlagige Leiterplatte mit Leiterplattensicherung**

(30) Priorität: 08.09.2010 DE 102010037390
(71) Anmelder: Vossloh-Schwabe Deutschland GmbH, 73660 Urbach (DE)
(72) Erfinder: Abele, Manfred, 73577 Ruppertshofen (DE)
(74) Vertreter: Rüger, Barthelt & Abel

(57) **Zusammenfassung**

Die Erfindung betrifft eine Mehrlagen-Leiterplatten (11) mit wenigstens (2) Platten (12), (13) und wenigstens einer zwischen zwei benachbarten Platten (12), (13) angeordneten Zwischenlage (14). Auf den beiden Außenseiten (17) der Mehrlagen-Leiterplatte (11) sind elektrische Leiterbahnen (18) vorhanden. Zumindest auf einer der beiden Außenseiten (17) sind elektrische und/oder elektronische Bauelemente (19) angeordnet und elektrisch kontaktiert. In der Zwischenebene (14) ist eine Sicherungsleiterbahn (25) angeordnet, die einen Sicherungsabschnitt (26) mit verringertem Querschnitt aufweist. Die Sicherungsleiterbahn (25) wird durch die beiden benachbarten Platten (12), (13) abgedeckt. Seitlich angrenzend an wenigstens einer der Platten (12), (13) sowie an die Zwischenlage (14) ist ein Löschvolumen (27) angeordnet, das Gas gefüllt und/oder mit einem festen Funkenlöschstoff (41) gefüllt sein kann. Das Löschvolumen (27) ist unter einem Durchschlagabstand (D) zum Sicherungsabschnitt (26) angeordnet. Der Durchschlagabstand (D) ist dabei als kleinster Abstand zwischen dem Sicherungsabschnitt (26) und dem Löschvolumen (27) definiert. Der Durchschlagabstand (D) ist kleiner als der Abstand des Sicherungsabschnitts (26) zu den anderen Leiterbahnen (18) in der Zwischenlage (14).

## Beschreibung

Die Erfindung betrifft eine mehrlagige Leiterplatte für ein elektrisches oder elektronisches Gerät. Die Leiterplatte weist mehrere Lagen auf, wobei in jeder Lage Leiterbahnen verlaufen können. Die Lagen werden durch wenigstens zwei aneinander befestigte Platten gebildet. Mindestens eine Zwischenlage zwischen zwei benachbarten Platten ist daher vorhanden. Derartige Mehrlagen-Leiterplatten sind seit langem bekannt.

Beispielsweise offenbart DE 100 05 836 B4 eine solche mehrlagige Leiterplatte. Dort ist auch eine Leiterplattensicherung beschrieben, die eine Sicherungsleiterbahn mit einem Sicherungsabschnitt aufweist, wobei der Sicherungsabschnitt gegenüber der übrigen Sicherungsleiterbahn einen verringerten Querschnitt aufweist. Er dient als Durchbrennbereich und unterbricht die Sicherungsleiterbahn, wenn zu große elektrische Leistungen an der Sicherungsleiterbahn anliegen, beispielsweise im Falle eines Kurzschlusses. Der Sicherungsabschnitt schmilzt durch oder verdampft. Eine Sicherungsleiterbahn kann ansonsten notwendige Sicherungsbauelemente ersetzen. Diese Sicherungsleiterbahn ist bei einem Ausführungsbeispiel der DE 100 05 836 B4 in einer Zwischenlage der mehrlagigen Leiterplatte (Multilayer-Platine) angeordnet.

In DE 37 23 832 A1 wird ferner eine Sicherungsleiterbahn beschrieben, deren Querschnitt im Sicherungsabschnitt dadurch verringert ist, dass die Sicherungsleiterbahn durchbohrt wird. Dadurch verzweigt sich die Sicherungsleiterbahn und es entstehen zwei parallel geschaltete Sicherungsabschnitte zu beiden Seiten der Bohrung. Wird die Bohrung nicht exakt mittig ausgeführt, entstehen zwei Sicherungsabschnitte unterschiedlichen Querschnitts. Die Sicherungsabschnitte sprechen deswegen bei unterschiedlichen Strömen an. Dies ist unerwünscht. Im Bereich der Sicherungsabschnitte um das Bohrloch herum ist die Sicherungsleiterbahn mit einem funkenlöschenden Medium abgedeckt, beispielsweise mittels eines Abdecklacks auf Silikonbasis.

Die aus DE 10 2008 047 730 A1 bekannte Sicherungsleiterbahn weist einen spiralförmigen Sicherungsabschnitt auf, der eine Induktivität bildet und in einer Zwischenlage angeordnet sein kann.

Aus DE 10 302 793 A1 ist eine Sicherung bzw. eine Sicherungsplatine insbesondere für Kraftfahrzeuge bekannt. Die Sicherung bzw. die Sicherungsplatine soll gegen Korrosion geschützt und kostengünstig hergestellt werden. Aus diesem Grund wird anstelle eines Aluminiumblechs ein metallischer Gusswerkstoff zur Herstellung der Sicherung verwendet. Auf diese Weise können die Sicherungen einschließlich der Schmelzstreifen im Druckgussverfahren in einem Schuss in einer Form gegossen werden.

Ausgehend vom bekannten Stand der Technik kann es als Aufgabe der vorliegenden Erfindung gesehen werden, die Betriebssicherheit der Leiterplatte bzw. des mit der Leiterplatte ausgestatteten elektrischen oder elektronischen Geräts zu erhöhen, wobei gleichzeitig eine kompakte Bauweise erzielt werden soll.

Diese Aufgabe wird durch eine Leiterplatte mit den Merkmalen des Patentanspruches 1 gelöst.

Die Mehrlagen-Leiterplatte weist zumindest zwei Platten auf, die an jeweils wenigstens einer Plattenseite elektrisch leitfähige Leiterbahnen aufweisen. Zumindest an einer Plattenseite einer Platte sind außerdem elektrische und/oder elektronische Bauteile angeordnet. Die Leiterplatte weist eine Sicherungsleiterbahn mit einem Sicherungsabschnitt auf, dessen Querschnitt gegenüber der übrigen Sicherungsleiterbahn verringert ist. Der Sicherungsabschnitt dient als Durchbrennabschnitt. Er ist in einer Zwischenlage zwischen zwei aneinander befestigten Platten der Mehrlagen-Leiterplatte angeordnet und verläuft vorzugsweise geradlinig und insbesondere ohne Verzweigung. Bei einer alternativen Ausführungsform kann der Sicherungsabschnitt auch einen Knick, vorzugsweise einen Knick mit einem Knickwinkel von zumindest 45° bis 90° aufweisen, so dass der Sicherungsabschnitt beispielsweise eine L-Form aufweist. An der Knickstelle wird ein sehr gutes Abbrennverhalten erzielt. An der Knickstelle wird oft das Kupfer unterätzt und somit entsteht eine Sollbruchstelle die einen Vorteil beim Auslösen erzielt.

Bevorzugt ist der Querschnitt des Sicherungsabschnitts konstant. Dies erleichtert das Fertigen und Dimensionieren. Die benachbarten Platten der Mehrlagen-Leiterplatte dienen dabei sozusagen als Kühlkörper und können im Falle des Durchschmelzens oder Verdampfens des Sicherungsabschnitts beim Löschen des auftretenden Lichtbogens unterstützen. Das Kühlen kann auch dazu genutzt werden, um beispielsweise eine kurzzeitige Überlast zu tolerieren, so dass die Sicherung nicht sofort auslöst - Einschaltstromspitzen ("Inrushcurrent") beim Laden von Elektrolytkondensatoren oder anderen Kapazitäten,gegebenenfalls auch von Induktivitäten, die an Wechselspannungen betrieben werden, können auf diese Weise toleriert werden ohne dass der Sicherungsabschnitt getrennt wird.. Bei "echten" Sicherungen kann eine derartige kurzzeitige "Überlast" zum vorzeitigem Auslösen führen, da der Sicherungsdraht geschädigt wird. Hier bietet die erfindungsgemäße Lösung einen wesentlichen Vorteil. Die Alterung durch Einschaltimpulse kann verhindert oder zumindest verzögert werden. Die Sicherungsleiterbahn hat eine längere Lebensdauer als herkömmliche Sicherungen. Wenn herkömmliche Glas-Sicherungen nebeneinander platziert werden, heizen sich diese gegenseitig auf (oder durch die Umgebung), was zu einem verfrühten Auslösen auch im Nichtfehlerfall geführt hat. Durch die Sandwichbauweise wird die erfindungsgemäße Sicherungsleiterbahn gekühlt, was ein verfrühtes Auslösen zuverlässig verhindert und ein platzoptimiertes Ausnutzen der Leiterplattenfläche ermöglicht. Diese Bauweise erreicht auch eine sehr kurze Auslösezeit. Eine zusätzliche separate Abdeckschicht des Sicherungsabschnitts mit funkenlöschendem Material entfällt.

Wird der Sicherungsabschnitt zumindest teilweise verdampft, könnte die Mehrlagen-Leiterplatte unkontrolliert brechen. Um dies zu verhindern ist dem Sicherungsabschnitt ein Löschvolumen zugeordnet. Das Löschvolumen kann mit einem Löschstoff befüllt sein. Dieser Löschstoff kann gasförmig und/oder fest und/oder flüssig sein, wobei auch Mischzustände auftreten können in Form eines Schaums, eines Gels, einer Paste, einer Creme oder dergleichen Löschstoffen. Beispielsweise kann im Löschvolumen Luft vorhanden sein. Das Löschvolumen grenzt seitlich an die Zwischenlage und eine Kante oder Schmalseitenfläche wenigstens einer der benachbarten Platten an. Es befindet sich nicht zwischen dem Sicherungsabschnitt und einer unmittelbar benachbarten Platte, die den Sicherungsabschnitt abdeckt. Die an das Löschvolumen angrenzende Kante oder Schmalseitenfläche der Platte kann von einem Randabschnitt der Mehrlagen-Leiterplatte gebildet sein. Es ist auch möglich, dass die Kante oder Schmalseitenfläche an eine Plattenaussparung angrenzt, die zumindest die Zwischenlage und eine der angrenzenden Platten neben dem Sicherungsabschnitt durchsetzt. Zwischen dem Sicherungsabschnitt und dem Löschvolumen ist ein Durchschlagabstand vorgegeben, der kleiner ist als der Abstand zu den anderen Leiterbahnen in der Zwischenlage. Als Durchschlagabstand ist die kürzeste Distanz zwischen dem Sicherungsabschnitt und dem Löschvolumen zu verstehen. Der Durchschlagabstand ist vorzugsweise größer als Null. Es ist alternaiv aber auch möglich, dass der Sicherungsabschnitt unmittelbar an das Löschvolumen angrenzt. Beim Verdampfen oder Durchschmelzen des Sicherungsabschnitts können die entstehenden Gase durch das Löschvolumen aufgenommen werden. Ein unkontrolliertes Bersten oder Brechen der Mehrlagen-Leiterplatte wird dadurch vermieden. Der Metalldampf wird kontrolliert in das Löschvolumen eingeleitet. Von dort kann er bei einem bevorzugten Ausführungsbeispiel in die Umgebungsluft eintreten. Es ist auch möglich, dass das Löschvolumen von dem Teil der Umgebungsluft gebildet ist, der im Bereich des Sicherungsabschnitts mit dem Durchschlagabstand an den Rand der Mehrlagen-Leiterplatte angrenzt.

Vorzugsweise ist das Löschvolumen in wenigstens einer Plattenaussparung vorgesehen. Die wenigstens eine Plattenaussparung durchsetzt zumindest die angrenzende Platte sowie die Zwischenlage. Sie ist bevorzugt zumindest nach einer Plattenseite zur Umgebung hin offen. Vorzugsweise durchsetzt die Plattenaussparung alle Platten und alle Zwischenlagen der Mehrlagen-Leiterplatte. Die Plattenaussparung kann mithin eine sacklochartige oder nutartige Vertiefung oder auch eine die Mehrlagenleiterplatte vollständig durchsetzende Durchbrechung sein. Das Löschvolumen ist in diesem Fall durch die Plattenaussparung begrenzt. Die Plattenaussparung kann auf einer oder auf beiden Leiterplattenaußenseiten mit der Umgebung fluidisch verbunden sein. Bei anderen Ausführungsformen können die Plattenaussparungen abgedeckt sein, beispielsweise an den beiden Leiterplattenaußenseiten beim Eingießen der Mehrlagen-Leiterplatte in ein Gießharz. Die Plattenaussparung wird in diesem Fall ausreichend groß gewählt, sodass das Löschvolumen ausreicht, um das verdampfte Metall aufzunehmen und den Druck im Löschvolumen unter einem Druckgrenzwert zu halten, dass ein Bersten der Mehrlagen-Leiterplatte vermieden ist.

Das dem Sicherungsabschnitt der Sicherungsleiterbahn zugeordnete Löschvolumen kann in einer oder mehreren Platteaussparungen vorgesehen sein. Die Plattenaussparung kann im Querschnitt kreisrund oder schlitzförmig sein, was sich besonders einfach herstellen lässt. Es sind auch Kombinationen von Plattenaussparungen mit unterschiedlichen Querschnitten möglich. Die Plattenaussparungen können sehr einfach in die Platten der Mehrlagen-Leiterplatte gebohrt, gefräst, gestanzt oder auf andere Art und Weise eingebracht werden. Das Einbringen der Plattenaussparungen ist vor oder vorzugsweise nach dem Verbinden der einzelnen Platten zur Mehrlagen-Leiterplatte möglich.

Bei einer Weiterbildung der Mehrlagen-Leiterplatte kann im Löschvolumen, also beispielsweise in einer oder mehreren der Plattenaussparungen ein insbesondere fester Funkenlöschstoff vorgesehen sein. Es kann beispielsweise Sand, insbesondere Quarzsand verwendet werden, an dem die Metallpartikel des verdampften oder geschmolzenen Sicherungsabschnitts kondensieren.

Vorzugsweise weist die Leiterplatte mehrere Sicherungsleiterbahnen mit jeweils einem Sicherungsabschnitt auf. Insbesondere kann für jede verwendete Phase des Wechselstromnetzes eine Sicherungsleiterbahn mit einem Sicherungsabschnitt vorhanden sein. Auf diese Weise führt das Trennen eines Sicherungsabschnitts nicht zum vollständigen Ausfall des Geräts. Das elektrische und/oder elektronische Gerät kann noch mit den anderen beiden Phasen weiterbetrieben werden. Insbesondere bei einem Gerät zum Betreiben von Lampen kann dadurch ein kompletter Beleuchtungsausfall vermieden werden. Die mit den noch ungetrennten, leitenden Sicherungsleiterbahnen elektrisch verbundenen Lampen können noch betrieben werden. Denn aufgrund der erfindungsgemäßen Ausgestaltung der Mehrlagen-Leiterplatte mit dem Löschvolumen führt das Auftrennen eines Sicherungsabschnitts nicht zu einer unkontrollierten Zerstörung der Leiterplatte. Die übrigen elektrischen Verbindungen werden daher nicht unkontrolliert unterbrochen. Es können an einer Phase auch zwei oder mehr Sicherungsleiterbahnen angeschlossen werden, die unterschiedliche Baugruppen elektrischer oder elektronischer Bauteile mit Gleich- oder Wechselspannung versorgen (AC oder DC). So führt ein Ausfall einer Baugruppe ebenso wenig zum kompletten Abschalten des Geräts. Zum Beispiel kann das Gerät mehrere unabhängige Spannungs- oder Stromversorgungseinheiten für jeweils eine oder mehrere daran angeschlossene Leuchtmittel aufweisen, wie etwa bei einem RGB-Modul, das für jede Lichtfarbe (rot, grün, blau) eine separate Spannungs- oder Stromversorgung aufweist. Es können dabei beliebige Leuchtmittel verwendet werden, zum Beispiel Leuchtstofflampen, Niederdruck-Gasentladungslampen, Halbleiter-Leuchtmittel (wie Leuchtdioden), etc. Das verdampfte Metall, welches sich im Löschvolumen verteil hat, kann keinen Kurzschluss auf der Leiterplatte verursachen und die geforderten Sicherheitsabstände sind weiterhin eingehalten.

Sofern mehrere Sicherungsleiterbahnen vorhanden sind, können diese in verschiedenen Zwischenlagen der Mehrlagen-Leiterplatte angeordnet sein. Die einzelnen Sicherungsleiterbahnen werden auf diese Weise durch die isolierende Platte zwischen den unterschiedlichen Zwischenlagen voneinander getrennt, sodass eine gegenseitige Beeinträchtigung beim Schmelzen oder Verdampfen einer der Sicherungsabschnitte vermieden ist. Dabei besteht die Möglichkeit, jedem Sicherungsabschnitt jeweils ein separates Löschvolumen zuzuordnen, wobei zwischen dem Sicherungsabschnitt und dem zugeordneten Löschvolumen der Durchschlagabstand eingehalten wird. Der Abstand zu dem oder den weiteren Löschvolumen anderer Sicherungsabschnitte ist vorzugsweise größer als der Durchschlagabstand zum jeweils zugeordneten Löschvolumen. Dadurch lassen sich zu kurze Funkenstrecken zwischen zwei Sicherungsabschnitten in einem Löschvolumen vermeiden.

Die Größe des Löschvolumens kann an die Abschaltstromgröße angepasst werden, bei der die Sicherungsleitung auslösen soll. Dabei besteht auch die Möglichkeit, die Sicherungsleiterbahn, insbesondere den Querschnitt des Sicherungsabschnitts, an die geforderte oder gewünschte Abschaltströmgröße anzupassen. Je größer die Abschaltstromgröße ist, desto breiter ist der Sicherungsabschnitt und desto größer ist das Löschvolumen.

Vorteilhafte Ausgestaltungen der Erfindung ergeben sich aus den abhängigen Patentansprüchen sowie der Beschreibung. Die Beschreibung beschränkt sich auf wesentliche Merkmale der Erfindung. Die Zeichnung ist ergänzend heranzuziehen. Es zeigen:
Figur 1 eine schematische teilgeschnittene perspektivische Darstellung eines Ausführungsbeispiels der Mehrlagen-Leiterplatte mit zwei Platten und einer Zwischenlage,
Figur 2 eine schematische blockschaltbildähnliche Darstellung eines elektrischen Geräts mit einer Leiterplatte,
Figur 3a eine schematische Darstellung einer Sicherungsleiterbahn mit zugeordneten Plattenaussparungen kreisrunden Querschnitts,
Figur 3b eine schematische Darstellung einer Sicherungsleiterbahn mit zugeordneten schlitzförmigen Plattenaussparungen,
Figur 3c eine schematische Darstellung zweier Sicherungsleiterbahnen mit jeweils einer Knickstelle,
Figur 4 eine schematische Querschnittsansicht eines Ausführungsbeispiels der Leiterplatte mit einer Zwischenlage und zwei Platten,
Figur 5 eine schematische Querschnittsansicht eines Ausführungsbeispiels der Leiterplatte mit zwei Zwischenlagen und zwei Sicherungsleiterbahnen,
Figur 6 eine abgewandelte Ausführungsform der Leiterplatte nach Figur 5 in schematischer Querschnittsdarstellung,
Figur 7 eine abgewandelte Ausführungsform der Leiterplatte nach Figur 6 in schematischer Querschnittsdarstellung,
Figur 8 ein weiteres Ausführungsbeispiel der Leiterplatte in schematischer Querschnittsdarstellung,
Figur 9 ein Ausführungsbeispiel der Leiterplatte, die in Gießharz eingegossen ist, in schematischer Querschnittsdarstellung, und
Figur 10 eine schematische Darstellung einer Umschalteinrichtung zur Auswahl einer zu verwendenden Sicherungsleiterbahn der Mehrlagen-Leiterplatte.

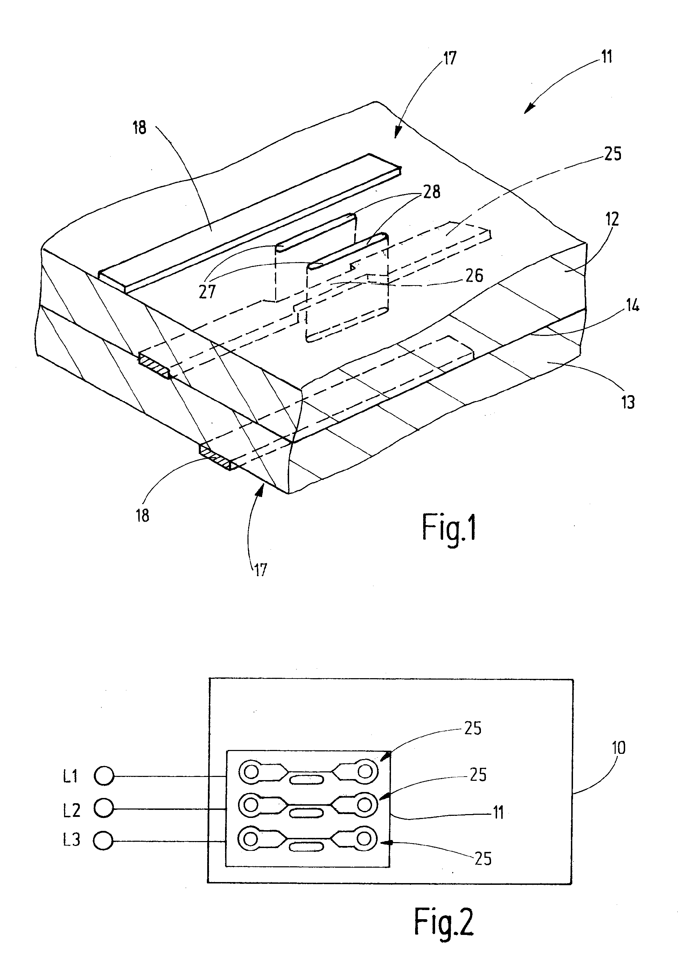

In Figur 2 ist schematisch ein elektrisches bzw. elektronisches Gerät 10 mit einer Mehrlagen-Leiterplatte 11 schematisiert dargestellt. Das Gerät 10 ist an zumindest eine und beispielsgemäß alle drei Phasen L1, L2, L3 eines Spannungsnetzes angeschlossen. Die Mehrlagen-Leiterpaltte 11 ist in den Figuren 1 sowie 4 bis 9 in verschiedenen Ausgestaltungen dargestellt.

Die Mehrlagen-Leiterplatte 11 weist zumindest eine erste Platte 12 sowie eine zweite Platte 13 auf. Zwischen den beiden Platten 12, 13 ist eine erste Zwischenlage 14 gebildet. Bei anderen hier beschriebenen Ausführungsformen ist ferner eine dritte Platte 15 vorgesehen, wodurch eine weitere, zweite Zwischenlage 16 gebildet ist. Die Anzahl der Platten 12, 13, 15 ist prinzipiell nicht begrenzt. Werden n Platten verwendet, so ergeben sich n-1 Zwischenlagen. Die beiden äußeren Platten 12, 13 bzw. 12, 15 weisen jeweils eine nach außen weisende Außenseite 17 auf. Auf zumindest einer der Außenseiten 17 sind elektrisch leitende Leiterbahnen 18 vorgesehen. Wenigstens eine der Außenseiten 17 dient auch zum Befestigen von elektrischen und/oder elektronischen Bauelementen 19. In den Zwischenlagen 14 bzw. 16 zwischen zwei aneinander liegenden Platten 12, 13 bzw. 13, 15 sind weitere Leiterbahnen 18 vorhanden.

Die Mehrlagen-Leiterplatte 11 weist ferner zumindest eine Sicherungsleiterbahn 25 auf. Die Sicherungsleiterbahn 25 enthält genau einen Sicherungsabschnitt 26 mit einem verringerten Leiterquerschnitt. Der Leiterquerschnitt des Sicherungsabschnitts 26 ist so gewählt, dass er bei definierten elektrischen Leistungen schmilzt oder verdampft. Der Sicherungsabschnitt 26 bildet mithin eine Schmelzsicherung. Die Sicherungsleiterbahn 25 ist in der ersten Zwischenlage 14 oder der zweiten Zwischenlage 16 zwischen zwei benachbarten Platten 12, 13, 15 angeordnet. Die beiden angrenzenden Platten 12, 13 bzw. 13, 15 liegen beispielsgemäß unmittelbar am Sicherungsabschnitt 26 an ohne Zwischenschaltung weiterer Materialschichten. Die Sicherungsleiterbahn 25 ist durch die beiden aneinander angrenzenden Platten 12, 13 bzw. 13, 15 flächig abgedeckt. Die beiden Platten 12, 13 bzw. 13, 15 bilden dabei Kühlkörper, sodass Wärme in der Sicherungsleiterbahn 25 insbesondere dann, wenn sich ein Lichtbogen ausbildet, über die beiden Platten abgeführt werden kann. Dies hat eine verbesserte Lichtbogenlöschung zur Folge. Pro an das Gerät 10 anschließbare Phase L1, L2, L3 ist eine Sicherungsleiterbahn 25 auf der Mehrlagen-Leiterplatte 11 vorhanden.

Die Platten 12, 13, 15 können beschichtete Papier-, Glas- oder Aramidgewebe sein. Als Beschichtung dient beispielsweise ein Harz. Die Leiterbahnen 18 sowie die Sicherungsbahn 25 bestehen vorzugsweise aus Kupfer. Es können auch Leiterplatten aus keramischen Materialien, Kunststoffen wie Polyamid, Polytetrafluorethylen, Aluminium oder anderen Materialien verwendet werden.

Die Platten 12, 13, 15 können starr oder flexibel sein. Sie werden derart aufeinander befestigt, beispielsweise verpresst, dass die Leiterbahnen 18 bzw. die Sicherungsleiterbahnen 25 in den Zwischenlagen ringsum abgeschlossen sind.

Die wenigstens eine Sicherungsleiterbahn 25 des Geräts 10 bildet eine Sicherung beispielsweise für die Schnittstelle eines dimmbaren Geräts. Da dort insbesondere größere Luft- und Kriechstrecken eingehalten werden müssen, ist die platzsparende, kompakte Realisierung der Sicherung in Form der Sicherungsleiterbahn von Vorteil. Die Sicherungsleiterbahn kann als Sicherung für alle Arten von Vorschalt- oder Betriebsgeräten zur Lampensteuerung verwendet werden. Es können alle Schnittstellen oder andere empfindliche Anschlüsse mit dieser Form der Sicherung geschützt werden, wie etwa Programmierschnittstellen, kleine Spannungsversorgungen (AC oder DC) für interne Controller, DALI-Schnittstellen, Sensoren, usw.

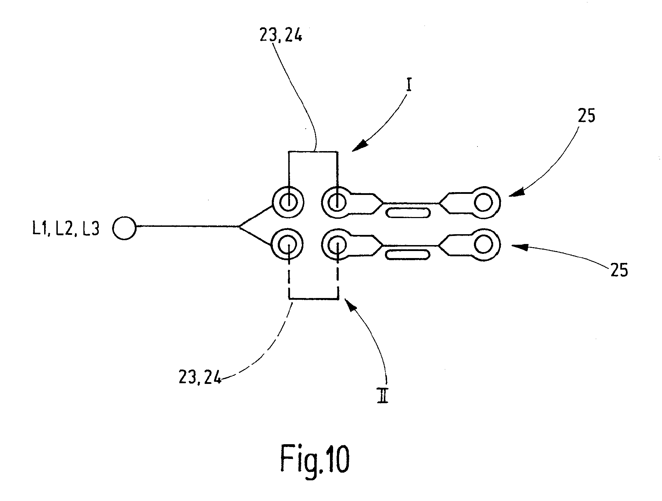

Die Mehrlagen-Leiterplatte 11 kann außerdem eine Auswahl- oder Ersatzsicherung bereitstellen (Figur 10). Hierfür können zwei oder mehr Sicherungsleiterbahnen 25 vorhanden sein, von denen stets nur eine Sicherungsleiterbahn 25 aktuell verwendet wird. Die Auswahl erfolgt über eine elektrische Umschalteinrichtung 23. Hat zum Beispiel die zuletzt verwendete Sicherungsleiterbahn 25 ausgelöst und ist dadurch dauerhaft getrennt, kann auf eine andere Ersatz-Sicherungsleiterbahn umgeschaltet werden. Es ist auch möglich, die Sicherungsleiternahnen 25 für unterschiedliche Abschaltstromgrößen auszulegen, so dass durch Auswahl einer der Sicherungsleiterbahnen 25 gleichzeitig die Abschaltstromgröße definiert wird. Als Umschalteinrichtung 23 kann beispielsweise ein einsetzbares Verbindungsstück 24 dienen, um die gewünschte Sicherungsleiternahn 25 zu aktivieren. Als Verbindungsstück 24 kann eine Lötbrücke, ein Steckverbinder (z.B. Jumper-Stecker) oder dergleichen verwendet werden, das die ausgewählte Sicherungsleiterbahn 25 in den Stromkreis durch Überbrücken einer Leitungsunterbrechung einbindet. Es ist dabei möglich, an lediglich einem oder an beiden Leiternahnenden 46 der Sicherungsleiterbahnen 25 eine Umschalteinrichtung 23 vorzusehen. Dieses Umschalten mittels des Verbindungsstücks 24 ist in Figur 10 schematisch veranschaulicht: das Verbindungsstück kann von seiner aktuellen Position I in die gestrichelt dargestellte Position II umgesteckt werden, um die andere Sicherungsleiterbahn 25 in den Stromkreis einzubinden. Das Umschalten bzw. Umstecken erfolgt auf einer der Außenseiten 17 der Mehrlagen-Leiterplatte 11. Die redundanten Sicherungsleiterbahnen 25 befinden sich in einer gemeinsamen oder in unterschiedlichen Zwischenlagen 14, 16.

Beim Schmelzen oder Verdampfen des Sicherungsabschnitts 26 könnte dies jedoch zum unkontrollierten Brechen der Mehrlagen-Leiterplatte 11 führen. Denn durch das Verdampfen entsteht ein Gas und mithin ein lokaler Druck in der Zwischenlage 14 bzw. 16 zwischen den benachbarten Platten 12, 13 bzw. 13, 15. Um die unkontrollierte Beschädigung der Mehrlagen-Leiterplatte 11 zu verhindern, ist dem Sicherungsabschnitt 26 jeder Sicherungsleitung 25 ein Löschvolumen 27 zugeordnet. Das beim Verdampfen des Sicherungsabschnitts 26 entstehende Gas kann in das Löschvolumen 27 entweichen und sich dort ausdehnen, sodass die Druckbelastung der Mehrlagen-Leiterplatte 11 reduziert ist.

Das Löschvolumen 27 ist vorzugsweise durch eine oder mehrere Plattenaussparungen 28 gebildet. Die Plattenaussparung 28 ist im Querschnitt durch die Leiterplatte 11 gesehen seitlich angrenzend an die Zwischenlage 14, 16 benachbart zur Sicherungsleitung 25 angeordnet. Sie durchsetzt zumindest die Zwischenlage 14, 16 sowie eine der angrenzenden Platten 12 oder 13 oder 15. Bei den hier beschriebenen bevorzugten Ausführungsformen durchsetzt die Plattenaussparung 28 alle Platten 12, 13, 15 sowie alle Zwischenlagen 14, 16 der Mehrlagen-Leiterplatte 11. Lediglich im Bereich der Außenseiten 17 der Mehrlagen-Leiterplatte 11 kann die Plattenaussparung 28 fluiddicht abgeschlossen sein. Das durch eine jeweilige Plattenaussparung 28 begrenzte Löschvolumen 27 erstreckt sich zumindest neben oder durch eine der Platten und vorzugsweise durch sämtliche Platten 12, 13, 15 hindurch. Anders ausgedrückt bilden die Kanten 30 der an die Plattenaussparung 28 angrenzenden Platten 12, 13, 15 die Mantelfläche der Plattenaussparung 28. Bei den hier beschriebenen Ausführungsbeispielen münden die Plattenaussparungen 28 auf den Außenseiten 17 aus.

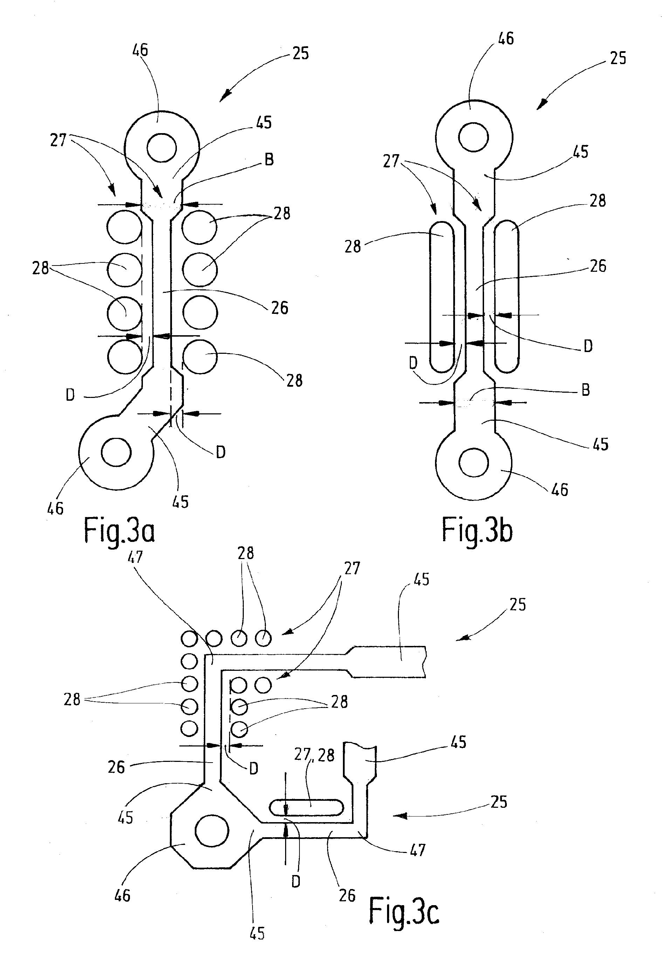

Jedem Sicherungsabschnitt 26 der Sicherungsleiterbahn 25 ist vorzugsweise ein separates Löschvolumen 27 zugeordnet, das durch eine oder mehrere Plattenausnehmungen 28 begrenzt werden kann. Bei den schematischen Darstellungen in den Figuren 3a und 3b sind jeweils auf beiden Seiten des Sicherungsabschnitts 26 Plattenausnehmungen 28 vorhanden, die das Löschvolumen 27 bilden. Es kann allerdings ausreichen, lediglich auf einer der beiden Seiten eine oder mehrere Plattenausnehmungen 28 vorzusehen. Der Querschnitt der Plattenausnehmungen 28 kann beispielsweise kreisrund oder aber länglich gewählt werden. Bei einem kreisrunden Querschnitt lassen sich die Plattenaussparungen 28 sehr einfach bohren. Die schlitzförmige Plattenausnehmung 28 kann beispielsweise durch Fräsen hergestellt werden. Auch andere Herstellungsverfahren wie etwa Stanzen sind möglich. Die Plattenaussparungen 28 können abschnittsweise vor dem Verbinden der Platten 12, 13, 15 zur Mehrlagen-Leiterplatte 11 in jeder Platte 12, 13, 15 oder nach dem Verbinden durch alle Platten 12, 13, 15 gleichzeitig eingebracht werden.

Die einem Sicherungsabschnitt 26 zugeordnete Plattenaussparung 28 ist mit einem vorgegebenen Durchschlagabstand D zum Sicherungsabschnitt 26 angeordnet. Der Durchschlagabstand D ist geringer, als der Abstand des Sicherungsabschnitts 26 zu den anderen Leiterbahnen 18 in derselben Zwischenlage 14 bzw. 16. Die Größe des Durchschlagsabstands D hängt von den jeweiligen Einsatzbedingungen der Mehrlagen-Leiterplatte 11 ab. Er ist so gering, dass er für das verdampfende Material des Sicherungsabschnitts 26 im Auslösefall den geringsten Widerstand in der Zwischenlage 14 bzw. 16 bildet, sodass die Materialdampfwolke sich in das Löschvolumen 27 ausdehnt. Der Durchschlagabstand D ist vorzugsweise geringer als die Breite B der Sicherungsleiterbahn 25 außerhalb des Sicherungsabschnitts 26. Beispielsweise ist der Durchschlagabstand D größer als null und kleiner als 5 mm.

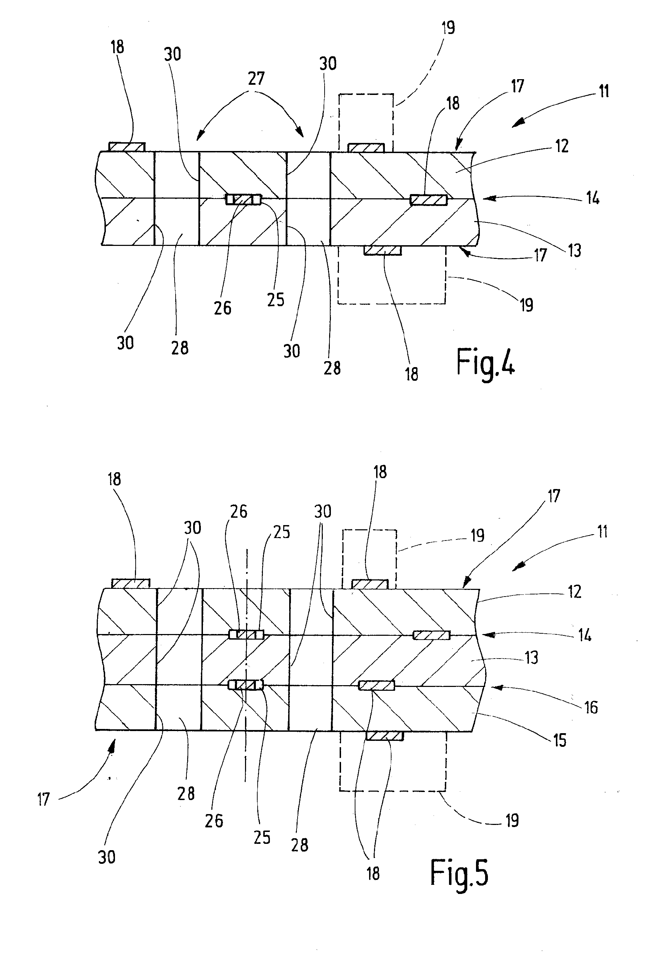

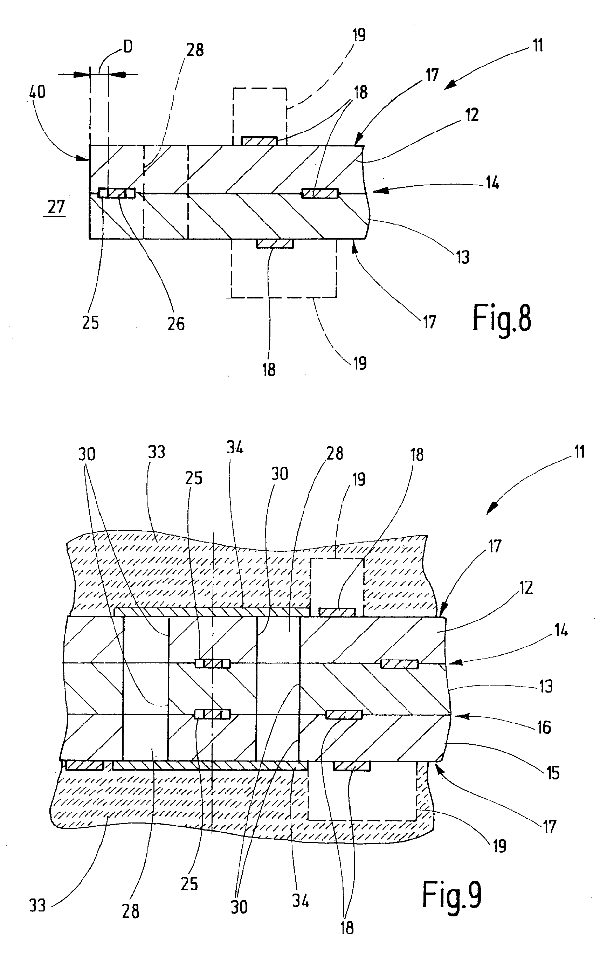

Bei den Ausführungsformen gemäß der Figuren 4 bis 7 sind die Plattenaussparungen 28 an den Außenseiten 17 der Mehrlagen-Leiterplatte 11 mit der Umgebung fluidisch verbunden. Die Mündungen der Plattenaussparungen 28 sind an den Außenseiten 17 unverschlossen. Im Unterschied hierzu ist in Figur 9 eine abgewandelte Ausführungsform dargestellt, bei der die Mehrlagen-Leiterplatte 11 beispielsweise in ein Harz 33 eingegossen ist. Um das Eindringen des Harzes 33 in die Plattenaussparungen 28 zu verhindern, sind diese durch eine Abdeckung 34 abgedeckt. Die Abdeckung 34 ist beispielsgemäß dünner als die Platten der Mehrlagen-Leiterplatte 11. Sie kann aus Papier und/oder Kunststoff sein. Beim Ausführungsbeispiel wird eine folienartige Abdeckung 34, zum Beispiel ein Klebeband oder eine Klebefolie oder ähnliches verwendet. Die folienartige Abdeckung 34 kann zum Beispiel an die jeweilige Außenseite 17 der Mehrlagen-Leiterplatte 11 geklebt sein. Alternativ könnte die folienartige Abdeckung 34 auch in einer Zwischenlage der Mehrlagen-Leiterplatte 11 angeordnet sein. Die folienartige Abdeckung 34 kann gleichzeitig die Funktion einer Lötstoppbeschichtung haben. Das Löschvolumen 27 in den Plattenaussparungen 28 ist dabei so bemessen, dass die darin vorhandene Luft das verdampfte Material des Sicherungsabschnitts 26 aufnehmen kann, ohne dass ein Druck entsteht, der die Mehrlagen-Leiterplatte 11 beschädigt und zu unkontrollierten Brüchen führt.

Während bei den Ausführungsbeispielen gemäß der Figuren 1 und 4 lediglich eine Sicherungsleiterbahn 25 vorhanden ist, weisen die Ausführungsformen gemäß der Figuren 5 bis 7 sowie 9 zwei Sicherungsleiterbahnen 25 auf, die vorzugsweise in unterschiedlichen Zwischenlagen 14, 16 angeordnet sind. Die eine Sicherungsleitung 25 befindet sich demnach in der ersten Zwischenlage 14, während die andere Sicherungsleiterbahn 25 in der anderen Zwischenlage 16 vorgesehen ist. Es versteht sich, dass auch eine dritte Sicherungsleiterbahn 25 in einer weiteren Zwischenlage vorgesehen sein könnte. Aus Gründen der Übersichtlichkeit sind in der Zeichnung maximal 3 Platten 12, 13, 15 und entsprechend zwei Zwischenlagen 14, 16 veranschaulicht.

Jeder Sicherungsleiterbahn 25 bzw. jedem Sicherungsabschnitt 26 ist eine Plattenaussparung 28 zugeordnet und unter dem Durchschlagabstand D benachbart angeordnet. Wie in den Figuren 5 und 9 beispielhaft gezeigt, können die beiden Sicherungsabschnitte 26 der beiden Sicherungsleiterbahnen 25 fluchtend übereinander angeordnet sein. Eine Ebene rechtwinklig zu den Außenseiten 17 der Mehrlagen-Leiterplatte 11 kann beide Sicherungsabschnitte 26 insbesondere mittig schneiden. Die beiden Sicherungsabschnitte 26 sind beispielsgemäß mittig zwischen den beiden Leiterplattenaussparungen 28 angeordnet. Dies ist dann möglich, wenn die Funkenstrecke zwischen den beiden Sicherungsabschnitten 26 in den verschiedenen Zwischenlagen 14, 16 durch beide Plattenausnehmungen 28 ausreichend groß ist.

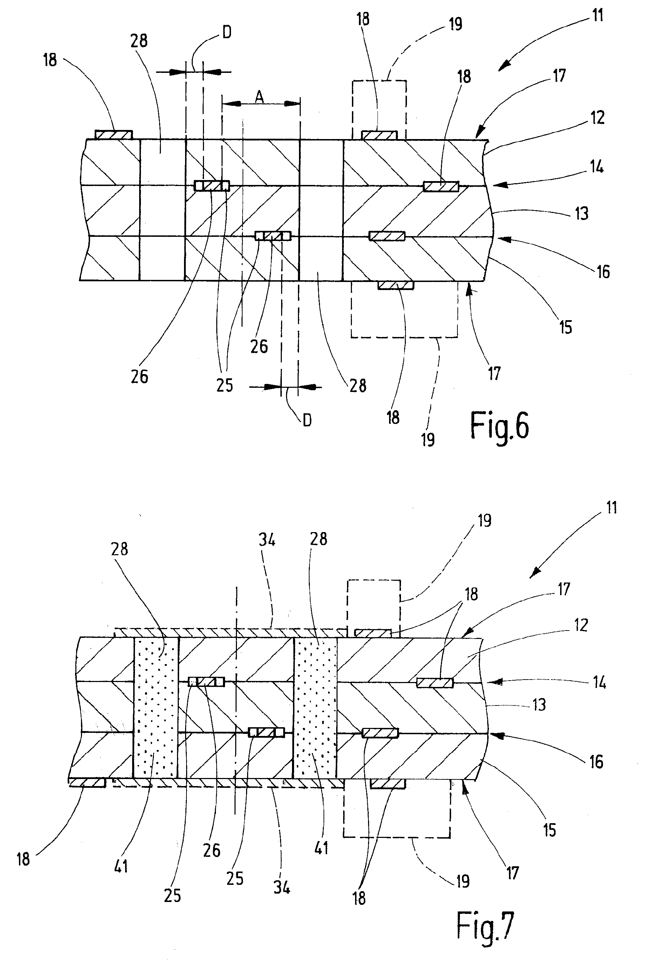

Alternativ hierzu besteht auch die Möglichkeit, die beiden Sicherheitsabschnitte 26 versetzt zueinander anzuordnen, sodass sie keine gemeinsame Mittellängsebene aufweisen. Bei den hier dargestellten Ausführungsbeispielen gemäß der Figuren 6 und 7 befinden sich die beiden Sicherungsabschnitte 26 auf unterschiedlichen Seiten einer Ebene, die rechtwinklig zu den Außenseiten 17 der Mehrlagen-Leiterplatte 11 zwischen den beiden Sicherungsabschnitten 26 verläuft. Somit nimmt jeder Sicherungsabschnitt 26 zu der ihm zugeordneten Plattenaussparung 28 bzw. zu dem ihm zugeordneten Löschvolumen 27 den Durchschlagabstand D ein, während der Abstand A zur jeweils anderen Plattenaussparung 28 bzw. zum jeweils anderen Löschvolumen 27 größer ist als der Durchschlagsabschnitt D. Bei den Ausführungsformen gemäß der Figuren 4 bis 7 und 9 befindet sich das einem Sicherungsabschnitt 26 zugeordnete Löschvolumen 27 bzw. die das Löschvolumen 27 begrenzende wenigstens eine Plattenausnehmung 28 in Verlaufsrichtung des Sicherungsabschnitt 26 gesehen ausschließlich auf einer Seite links oder rechts vom Sicherungsabschnitt 26.

Eine besondere Ausgestaltung der erfindungsgemäßen Mehrlagen-Leiterplatte 11 ist in Figur 8 dargestellt. Dort ist das Löschvolumen 27 durch einen Teil des Luftvolumens der Umgebungsluft gebildet, der an einen Außenkantenbereich 40 der Mehrlagen-Leiterplatte 11 angrenzt. In diesem Fall kann eine Plattenaussparung 28 entfallen. Der Sicherungsabschnitt 26 der Sicherungsleiterbahn 25 ist mit Durchschlagabstand D zum Außenkantenbereich 40 angeordnet.

Anordnungen der Sicherungsleiterbahnen wie in Figur 8 oder auch in den Figuren 5-7 können besonders Platz sparend sein, insbesondere im Vergleich zur Verwendung von einlagigen Leiterplatten und der dann notwendigen Anordnung mehrerer Sicherungsleiterbahnen auf der Oberfläche einer solchen Leiterplatte unter Einhaltung der erforderlichen Luft- und Kriechstrecken.

In den Figuren 3a und 3b ist die Sicherungsleiterbahn 25 schematisch veranschaulicht. Die Länge des Sicherungsabschnitts 26 ist deutlich größer als seine quer dazu gemessene Breite. Der Sicherungsabschnitt 26 verläuft gerade ohne Knicke und Verzweigungen. Er weist einen konstanten Querschnitt auf. Im Anschluss an den Sicherungsabschnitt 26 verbreitert sich die Sicherungsleiterbahn 25 in einem jeweiligen Endbereich 45. Der Endbereich 45 kann gerade in Richtung des Sicherungsabschnitts 26 verlaufen oder alternativ auch Knickstellen aufweisen, wie dies in Figur 3a beispielhaft zu sehen ist. Der Endbereich geht in ein Leiterbahnende 46 über, so dass die Sicherungsleiterbahn 25 zwischen zwei Leiterbahnenden 46 verläuft. Am Leiterbahnende 46 kann jeweils ein Lötauge, eine Durchkontaktierung oder ein SMD-Pad zum Anbringen eines SMD-Bauelements vorhanden sein.

Figur 3c veranschaulicht eine weitere Ausführungsform einer Sicherungsleiterbahn 25. Bei dieser Ausgestaltung sind mehrere und beispielsgemäß zwei Sicherungsleiterbahnen 25 einer Phase L1, L2 oder L3 des Spannungsnetzes zugeordnet. Sie weisen deswegen ein gemeinsames Leiterbahnende 46 auf. Jede Sicherungsleiterbahn 25 dient zur Absicherung einer jeweils angeschlossenen separaten Baugruppe von elektrischen und/oder elektronischen Bauelementen, beispielsweise unterschiedlichen Strom- oder Spannungsversorgungen des Geräts 10. Wie im Zusammenhang mit den Figuren 3a und 3b beschrieben, ist jeder Sicherungsleiterbahn 25 ein separates Löschvolumen 27 in Form von einer oder mehreren Aussparungen 28 zugeordnet. Die beiden Sicherungsabschnitte 26 weisen jeweils eine Knickstelle 47 auf. Der Knickwinkel ist vorzugsweise größer als 45° und beim Ausführungsbeispiel etwa ein 90°-Winkel. Mithin haben die Sicherungsabschnitte 26 eine L-Form.

Die Erfindung betrifft eine Mehrlagen-Leiterplatte 11 mit wenigstens zwei Platten 12, 13 und wenigstens einer zwischen zwei benachbarten Platten 12, 13 angeordneten Zwischenlage 14. Auf einer oder auf beiden Außenseiten 17 der Mehrlagen-Leiterplatte 11 sind elektrische Leiterbahnen 18 vorhanden. Zumindest auf einer der beiden Außenseiten 17 sind elektrische und/oder elektronische Bauelemente 19 angeordnet und elektrisch kontaktiert. In der Zwischenebene 14 ist eine Sicherungsleiterbahn 25 angeordnet, die einen Sicherungsabschnitt 26 mit verringertem Querschnitt aufweist. Die Sicherungsleiterbahn 25 wird durch die beiden benachbarten Platten 12, 13 abgedeckt. Seitlich angrenzend an wenigstens einer der Platten 12, 13 sowie an die Zwischenlage 14 ist ein Löschvolumen 27 angeordnet, das Gas gefüllt und/oder mit einem festen Funkenlöschstoff 41 gefüllt sein kann. Das Löschvolumen 27 ist unter einem Durchschlagabstand D zum Sicherungsabschnitt 26 angeordnet. Der Durchschlagabstand D ist dabei als kleinster Abstand zwischen dem Sicherungsabschnitt 26 und dem Löschvolumen 27 definiert. Der Durchschlagabstand D ist kleiner als der Abstand des Sicherungsabschnitts 26 zu den anderen Leiterbahnen 18 in der Zwischenlage 14. Die Plattenaussparungen 28 können vollständig oder teilweise mit einem Funkenlöschstoff 41 befüllt sein, wie dies schematisch in Figur 7 gezeigt ist. Der Funkenlöschstoff 41 ist vorzugsweise aus festem Material. Bei rieselfähigem Funkenlöschstoff 41 können die Plattenaussparungen 28 auf den Außenseiten 17 durch die folienartige Abdeckung 34 oder eine ähnliche Abdeckung verschlossen sein.

### Bezugszeichenliste:

- 10: Gerät
- 11: Mehrlagen-Leiterplatte
- 12: erste Platte
- 13: zweite Platte
- 14: erste Zwischenlage
- 15: dritte Platte
- 16: zweite Zwischenlage
- 17: Außenseite
- 18: Leiterbahn
- 19: Bauelement
- 23: Umschalteinrichtung
- 24: Verbindungsstück
- 25: Sicherungsleiterbahn
- 26: Sicherungsabschnitt
- 27: Löschvolumen
- 28: Plattenaussparung
- 30: Kante v. 12, 13, 15
- 33: Harz
- 34: Abdeckung
- 40: Außenkantenbereich
- 41: Funkenlöschstoff
- 45: Endbereich v. 25
- 46: Leiterbahnende
- 47: Knickstelle
- A: Abstand
- D: Durchschlagabstand
- L1: Phase
- L2: Phase
- L3: Phase

## Patentansprüche

1. Mehrlagige Leiterplatte für ein elektrisches oder elektronisches Gerät (10),
mit wenigstens zwei Platten (12, 13, 15), die jeweils zumindest an einer Plattenseite (17) elektrisch leitfähige Leiterbahnen (18) aufweisen,
mit wenigstens einer Sicherungsleiterbahn (25), die einen Sicherungsabschnitt (26) mit verringertem Querschnitt aufweist, und in einer Zwischenlage (14,16) zwischen zwei aneinander befestigten Platten (12,13,15) angeordnet ist,
mit einem an eine Kante (40) der Zwischenlage (14,16) und eine Kante (40) wenigstens einer der Platten (12, 13, 15) angrenzenden Löschvolumen (27), wobei zwischen dem Sicherungsabschnitt (26) und dem Löschvolumen (27) ein Durchschlagabstand (D) vorgegeben ist, der kleiner ist als der Abstand zu den anderen Leiterbahnen (18) in der Zwischenlage (14, 16).

2. Leiterplatte nach Anspruch 1,
**dadurch gekennzeichnet, dass** das Löschvolumen (27) mit der Umgebungsluft fluidisch verbunden ist.

3. Leiterplatte nach Anspruch 1,
**dadurch gekennzeichnet, dass** das Löschvolumen (27) in wenigstens einer Plattenaussparung (28) vorgesehen ist, die zumindest eine an die Zwischenlage angrenzende Platte (12, 13, 15) durchsetzt.

4. Leiterplatte nach Anspruch 3,
**dadurch gekennzeichnet, dass** die wenigstens eine Plattenaussparung (28) alle Platten (12, 13, 15) und dazwischen liegende Zwischenlagen (14, 16) der Leiterplatte (11) vollständig durchsetzt.

5. Leiterplatte nach Anspruch 3,
**dadurch gekennzeichnet, dass** die wenigstens eine Plattenaussparung (28) einen Teil der Platten und die zwischen diesen Platten angeordneten Zwischenlagen durchsetzt und lediglich zu einer der beiden Außenseiten der Leiterplatte (11) offen ist.

6. Leiterplatte nach Anspruch 3,
**dadurch gekennzeichnet, dass** der Querschnitt der Plattenaussparung (28) kreisrund oder schlitzförmig ist.

7. Leiterplatte nach Anspruch 1,
**dadurch gekennzeichnet, dass** im Löschvolumen (27) ein fester Funkenlöschstoff (41) vorhanden ist.

8. Leiterplatte nach Anspruch 1,
**dadurch gekennzeichnet, dass** mehrere Sicherungsleiterbahnen (25) mit jeweils einem Sicherungsabschnitt (26) vorhanden sind.

9. Leiterplatte nach Anspruch 8,
**dadurch gekennzeichnet, dass** für jede verwendete Phase (L1, L2, L3) des Stromnetzes eine Sicherungsleiterbahn (25) vorhanden ist.

10. Leiterplatte nach Anspruch 8,
**dadurch gekennzeichnet, dass** die Sicherungsleiterbahnen (25) und/oder die Sicherungsabschnitte (26) in verschiedenen Zwischenlagen (14,16) vorgesehen sind.

11. Leiterplatte nach Anspruch 10,
**dadurch gekennzeichnet, dass** den in verschiedenen Zwischenlagen (14, 16) angeordneten Sicherungsabschnitten (26) jeweils ein Löschvolumen (27) zugeordnet ist und der Abstand (A) zum jeweils anderen Löschvolumen (27) größer ist als der Durchschlagabstand (D) zum zugeordneten Löschvolumen (27).

12. Leiterplatte nach Anspruch 8,
**dadurch gekennzeichnet, dass** eine Umschalteinrichtung (23) zur Auswahl des aktuell zu verwendenden Sicherungsleiters (25) vorhanden ist.

13. Leiterplatte nach Anspruch 12,
**dadurch gekennzeichnet, dass** durch die Umschalteinrichtung (23) nur einer der Sicherungsleiter (25) einer Gruppe aus mehreren alternativen Sicherungsleitern (25) in den Stromkreis des Geräts (10) eingebunden wird.
